# DEMANDE DE BREVET EUROPEEN

(11) **EP 3 293 637 A1**
(43) Date de publication de la demande: **14.03.2018**
(21) Numéro de dépôt: 17156412.3
(22) Date de dépôt: 16.02.2017
(51) Int. Cl.: G06F 12/02

(54) **GESTION D'INDEX DANS UNE MÉMOIRE FLASH**

(30) Priorité: 09.09.2016 FR 1658442
(71) Demandeur: PROTON WORLD INTERNATIONAL N.V., 1831 Diegem (BE)
(72) Inventeur: DAWIRS, Michel, 1970 WEZEMBEEK-OPPEM (BE); DOCQUIER, Guillaume, 4000 LIEGE (BE)
(74) Mandataire: Thibon, Laurent

(57) **Abrégé**

L'invention concerne un procédé de gestion d'une mémoire flash, dans lequel : les données à stocker sont organisées en blocs logiques (Bi) ; la mémoire est divisée en pages ; et chaque page est divisée en trames (F), chaque trame pouvant contenir au moins un bloc de données et au moins un premier mot de métadonnées de trame contenant tout ou partie des valeurs d'index du bloc de données dans un arbre d'index, une valeur d'index correspondant à l'adresse d'une trame.

## Description

### Domaine

La présente description concerne de façon générale les circuits électroniques et, plus particulièrement, les circuits exploitant une mémoire flash. La présente description vise plus particulièrement la gestion d'une mémoire flash.

### Exposé de l'art antérieur

Les mémoires flash sont de plus en plus utilisées dans des microcontrôleurs pour stocker de façon non volatile des informations.

Le stockage de données dans une mémoire flash présente diverses contraintes temporelles liées à la granularité des opérations réalisées, l'écriture s'effectuant par mot (par exemple, par mot de quatre octets) tandis que l'effacement s'effectue par page de plusieurs mots (quelques dizaines à quelques centaines de mots).

Dans certaines applications, on souhaite s'assurer que les transactions réalisées et stockées respectent un critère d'atomicité. L'atomicité d'une transaction correspond à s'assurer que des données stockées en mémoire présentent bien un état exploitable et intègre. Cela revient à s'assurer que des données en mémoire non volatile présentent soit l'état avant la transaction soit l'état après la transaction concernée mais qu'elles ne présentent pas un état intermédiaire.

La gestion de l'atomicité des transactions est particulièrement utilisée dans des applications où une interruption de l'alimentation du circuit ou l'apparition d'une perturbation accidentelle ou volontaire peut engendrer le stockage de données dans un état les rendant soit inexploitables par la suite soit vulnérables du point de vue de la confidentialité ou de leur intégrité. Par exemple, dans le domaine des cartes à microcircuit, on souhaite s'assurer qu'en cas d'arrachement (tearing) volontaire ou accidentel d'une carte du lecteur dans laquelle elle se trouve, les informations contenues dans une mémoire flash de la carte soient fiables. Dans un circuit intégrant un module de sécurité, l'équivalent de l'arrachement correspond à une coupure de l'alimentation du circuit.

La gestion des opérations dans une mémoire flash requiert également de savoir où se trouve une donnée ainsi que de savoir où écrire de nouvelles données. En effet, parcourir toute la mémoire est très couteux en temps.

### Résumé

Il existe un besoin d'améliorer la gestion du stockage d'informations dans une mémoire flash, en particulier pour préserver le caractère atomique de certaines transactions impliquant une mise à jour de données dans la mémoire flash.

Il existe également un besoin d'améliorer l'accès aux données dans une mémoire flash.

Un mode de réalisation pallie tout ou partie des inconvénients des techniques connues de gestion d'une mémoire flash.

Un mode de réalisation facilite la recherche des données dans une mémoire flash.

Un mode de réalisation facilite la gestion d'atomicité des transactions dans une mémoire flash.

Ainsi, un mode de réalisation prévoit un procédé de gestion d'une mémoire flash, dans lequel :
les données à stocker sont organisées en blocs logiques ;
la mémoire est divisée en pages ;
chaque page est divisée en trames, chaque trame pouvant contenir au moins un bloc de données et au moins un premier mot de métadonnées de trame contenant tout ou partie des valeurs d'index du bloc de données dans un arbre d'index, une valeur d'index correspondant à l'adresse d'une trame.

Selon un mode de réalisation, pour chaque niveau d'index, seules les valeurs issues du niveau précédent sont stockées.

Selon un mode de réalisation, pour chaque niveau d'index, seules les valeurs issues du niveau précédent à l'exception de la valeur correspondant au bloc concerné sont stockées.

Selon un mode de réalisation, un ou plusieurs premiers niveaux d'index sont traités dans une mémoire volatile du circuit contenant la mémoire flash.

Selon un mode de réalisation, toutes les valeurs desdits un ou plusieurs premiers niveaux d'index sont stockées dans des métadonnées de chaque page.

Selon un mode de réalisation, les trames sont écrites séquentiellement dans une page.

Selon un mode de réalisation, la lecture d'un bloc de données comporte au moins les étapes suivante :
lire la dernière trame écrite dans la mémoire ;
remonter de trame en trame en interprétant les valeurs de ces trames jusqu'à atteindre la trame contenant le bloc recherché.

Selon un mode de réalisation, une écriture d'un bloc logique dans la mémoire s'accompagne d'une programmation d'un deuxième mot de métadonnées de trame avec un identifiant de ce bloc logique.

Selon un mode de réalisation, le deuxième mot de métadonnées de trame contient également une valeur représentative d'un code de contrôle d'erreur calculé au moins à partir du bloc de données de la trame.

Selon un mode de réalisation, lors de l'écriture d'une trame, un troisième mot de métadonnées de trame est écrit en premier avec une valeur, indépendante du contenu de la donnée à écrire et qui est toujours la même pour une trame donnée.

Selon un mode de réalisation, ledit troisième mot de métadonnées a une valeur fixe pour toutes les trames de la mémoire.

Selon un mode de réalisation, chaque page comporte au moins un mot de métadonnées de page qui contient, lorsqu'une page est écrite, une valeur d'un compteur de nombre de pages écrites, la page dans laquelle procéder à une écriture étant choisie comme étant celle dont le premier mot de métadonnées de page contient la valeur maximum du compteur de pages écrites parmi toutes les pages.

Selon un mode de réalisation, ledit premier mot de métadonnées de page est écrit avant écriture d'une première trame dans la page.

Selon un mode de réalisation, un circuit de gestion de la mémoire effectue, à chaque démarrage, une vérification d'atomicité de la dernière trame écrite.

Un mode de réalisation prévoit une mémoire flash, programmée conformément au procédé ci-dessus.

Un mode de réalisation prévoit un circuit électronique comportant une mémoire flash.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon très schématique et sous forme de blocs, un mode de réalisation d'un circuit électronique du type auquel s'appliquent, à titre d'exemple, les modes de réalisation qui vont être décrits ;
la figure 2 illustre un mode de réalisation d'une organisation logique de données à stocker dans une mémoire flash ;
la figure 3 illustre un mode de réalisation d'une organisation physique de données dans une mémoire flash ;
la figure 4 illustre, de façon très schématique, un mode de réalisation d'une structure de trame de la mémoire de la figure 3 ;
la figure 5 représente, de façon très schématique un exemple de structure d'un index de recherche de données dans une mémoire flash ;
la figure 6 est un schéma-blocs illustrant un mode de réalisation d'une écriture d'une donnée dans la mémoire ;
la figure 7 est un schéma-blocs illustrant un mode de réalisation d'une préparation d'une page suivante pour écriture quand une page courante est pleine ;
la figure 8 est un schéma-blocs illustrant un mode de réalisation d'une lecture d'une donnée dans la mémoire ;
la figure 9 est un schéma-blocs illustrant un mode de réalisation d'une récupération d'atomicité au niveau d'une page ; et
la figure 10 est un schéma-blocs illustrant un mode de réalisation d'une sélection d'une page à effacer selon le deuxième aspect.

### Description détaillée

De mêmes éléments ont été désignés par de mêmes références aux différentes figures.

Par souci de clarté, seuls les étapes et éléments utiles à la compréhension des modes de réalisation qui vont être décrits ont été représentés et seront détaillés. En particulier, le fonctionnement électrique d'une mémoire flash lors des étapes d'écriture, de lecture et d'effacement n'a pas été détaillé, les modes de réalisation décrits étant compatibles avec les technologies usuelles des mémoires flash. De plus, les applications utilisant une gestion d'atomicité n'ont pas non plus été détaillées, les modes de réalisation décrits étant, là encore, compatibles avec les applications usuelles.

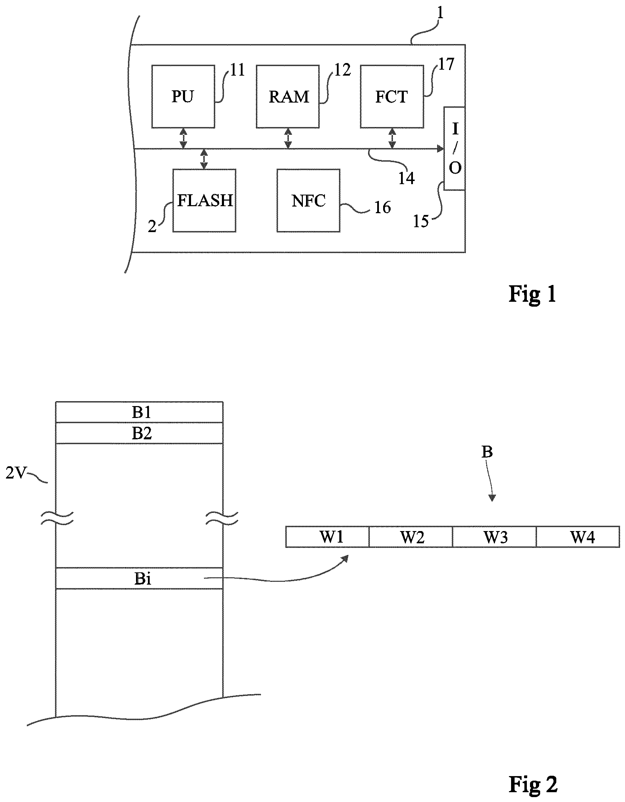

La figure 1 représente, de façon très schématique et sous forme de blocs, un mode de réalisation d'un circuit électronique 1 du type auquel s'appliquent, à titre d'exemple, les modes de réalisation qui vont être décrits.

Le circuit 1 comporte :
une unité de traitement 11 (PU), par exemple une machine d'états, un microprocesseur, un circuit logique programmable, etc. ;
une ou plusieurs zones 12 (RAM) de stockage volatil, par exemple de type mémoire RAM ou registres, pour stocker temporairement des informations (instructions, adresses, données) pendant les traitements ;
une ou plusieurs zones de stockage non volatil, dont au moins une mémoire 2 de type flash (FLASH) pour stocker des informations de façon durable et en particulier quand le circuit n'est pas alimenté ;
un ou plusieurs bus 14 de données, d'adresses et/ou de commandes entre les différents éléments internes au circuit 1 ; et
une interface d'entrée-sortie 15 (I/O) de communication, par exemple de type bus série, avec l'extérieur du circuit 1.

Le cas échéant, le circuit 1 intègre également un circuit 16 de communication sans contact (CLF - ContactLess Front-end), de type communication en champ proche (Near Field Communication - NFC).

Par ailleurs, le circuit 1 peut intégrer d'autres fonctions, symbolisées par un bloc 17 (FCT), selon l'application, par exemple, un crypto-processeur, d'autres interfaces, d'autres mémoires, etc.

La gestion de l'atomicité des transactions dans un circuit équipé d'une mémoire flash est particulière car la mémoire flash ne présente pas la même granularité de traitement selon le type d'opération. En particulier, l'écriture s'effectue par mot (d'un octet ou de quelques octets) tandis que l'effacement s'effectue par page. La taille d'un mot correspond généralement à la taille d'un registre recevant les données en série pour les transférer en parallèle au plan mémoire pour écriture. Une page est définie comme la taille minimale susceptible d'être adressée simultanément pour effacement. Typiquement, une page représente, dans une mémoire flash, 64, 128, 256, 512 ou 1024 octets.

Une mémoire flash se programme, à partir d'un état initial, désigné arbitrairement 1, vers des états 0 (états non conducteurs des cellules). Cela signifie que les cellules de la mémoire doivent être initialisées à un état haut (effacement) et que, pour stocker une donnée (écriture), on intervient (programmation à 0) ou pas (état du bit à 1) sur les états des bits par mot de données.

Afin de garantir l'atomicité des transactions, le stockage en mémoire flash d'une donnée ne doit être considéré comme valide qu'une fois que la transaction est terminée et que les données sont dites stables. En pratique, les procédés de gestion d'atomicité activent un indicateur de traitement d'une donnée lorsque celle-ci est extraite de la mémoire non volatile, puis organisent le stockage de la donnée mise à jour, une fois le traitement terminé, l'indicateur de traitement change alors d'état. L'atomicité peut concerner une quantité plus ou moins importante de données selon la nature de la transaction.

Le caractère atomique des transactions est particulièrement important dans le cas de transactions de type bancaire (paiement par exemple) où il est nécessaire de s'assurer que l'information stockée dans la mémoire flash, par exemple le solde d'un porte-monnaie électronique ou d'une autorisation d'achat, ou l'identifiant validant une transaction, est stocké de façon fiable.

Généralement, pour garantir l'atomicité d'une transaction, on utilise des espaces de stockage temporaire (Buffer) d'atomicité qui sont mis à jour avec les informations initiales, puis finales, pour transfert dans la mémoire non volatile principale.

Toutefois, dans le cas d'une mémoire flash, une difficulté réside dans la procédure d'effacement en raison de sa granularité par page qui est relativement longue par rapport à l'opération d'écriture par mot. En particulier, il existe un besoin d'indiquer qu'une page effacée est stable, c'est-à-dire qu'elle a pu être effacée intégralement. Autrement, on introduit une faiblesse dans la sécurité des données. Par ailleurs, en cas de besoin d'effacement d'une page avec transfert de données dans une nouvelle page, ce transfert peut rendre instable des données stables présentes dans la page à effacer. Cela se produit plus particulièrement avec des pages de grande taille (par exemple de l'ordre d'une centaine de mots voire plus) car elles sont plus susceptibles de contenir des données anciennes considérées comme stables et qu'il faut transférer dans une nouvelle page.

Une autre difficulté réside dans le fait de savoir où se trouve une information dans la mémoire. En effet, l'adressage logique effectué par l'exécution d'un programme (d'une application utilisant la mémoire) est différent de l'adressage physique dans la mémoire. Or, en raison de la granularité d'écriture et d'effacement d'une mémoire flash, il n'est pas souhaitable, pour une question de place, de stocker dans la mémoire flash elle-même une table de conversion d'adresses. Sans cette table, il est cependant nécessaire de parcourir (lire) toute la mémoire jusqu'à tomber sur la donnée recherchée. Une autre solution est, à l'allumage du circuit, de parcourir (lire) toute la mémoire une fois afin de générer (calculer) un index ou table de correspondance qui est alors stocké en mémoire volatile (RAM). Cette table doit être recalculée à chaque réinitialisation ou mise sous tension en raison du caractère volatil des données en mémoire RAM. Non seulement, cela requiert un temps de calcul non négligeable à chaque démarrage, mais également la table calculée occupe une place importante en mémoire RAM.

Dans les applications sans contact, les transactions doivent être effectuées très rapidement en raison du caractère fugace de la communication qui est lié à la durée pendant laquelle le circuit 1 peut communiquer avec un terminal. Or, la gestion de l'atomicité des transactions en utilisant des tampons en mémoire flash prend du temps, en raison des opérations d'effacement qui sont nécessaires pour autoriser une programmation. Par ailleurs, la gestion des accès à la bonne donnée prend également du temps.

Selon les modes de réalisation qui vont être décrits, on prévoit d'organiser de façon particulière le stockage des données dans la mémoire.

La figure 2 illustre un mode de réalisation d'une organisation logique de données à stocker dans une mémoire flash. En d'autres termes, cette figure illustre la façon dont sont gérées les données par l'unité de traitement 11 et les différentes entités du circuit 1 de la figure 1 pour stockage dans la mémoire flash. On fait référence par la suite à un circuit de gestion de la mémoire chargé d'organiser son adressage, l'écriture, la lecture et l'effacement ainsi que la conversion d'adresses logiques en adresses physiques. Ce circuit ou unité de gestion, est un circuit programmé selon la mise en oeuvre du procédé décrit et est, le cas échéant, l'unité de traitement.

Selon ce mode de réalisation, l'ensemble des données représentant la capacité de stockage de la mémoire flash est vu comme un seul réseau 2V de données en blocs B1, B2, etc. et chaque bloc Bi contient un même nombre de mots W. Dans l'exemple représenté en figure 2, on suppose que chaque bloc de donnée Bi contient quatre mots W1, W2, W3 et W4. La taille d'un mot correspond à la granularité d'écriture dans la mémoire flash, soit en pratique de un à quelques octets (par exemple quatre). Toutefois, il s'agit d'un exemple arbitraire et tout autre nombre d'un ou plusieurs octets peut constituer un mot et tout autre nombre d'un ou plusieurs mots peut constituer un bloc. Ainsi, le découpage logique de la mémoire flash n'est pas effectué par page mais par bloc B dont la taille est indépendante de la taille des pages.

Une donnée A à stocker dans la mémoire 2 comporte un nombre d'octets arbitraire, indépendant de la taille d'un bloc. D'un point de vue logique, c'est-à-dire pour l'unité de traitement 11, une donnée est définie par une longueur L(A), c'est-à-dire un nombre d'octets et sa position dans le réseau 2V de blocs Bi par un offset O(A), c'est-à-dire un décalage par rapport au début du réseau 2V.

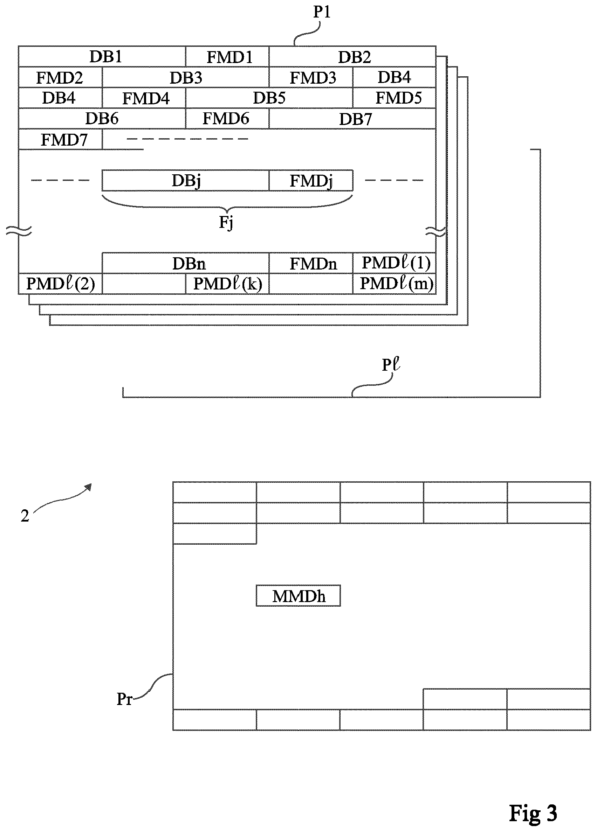

La figure 3 illustre un mode de réalisation d'une organisation physique de données dans une mémoire flash.

La transition entre l'organisation logique (figure 2) et l'organisation physique du stockage des données est transparente pour l'unité de traitement 11 et les autres circuits accédant à la mémoire. L'unité de gestion de la mémoire 2 convertit, en utilisant une table d'index ou de correspondance, des adresses virtuelles fournies par les différentes entités en des adresses physiques. Par ailleurs, pour gérer l'atomicité, l'unité de gestion génère des métadonnées qui sont stockées également dans la mémoire 2.

Afin de respecter la contrainte d'effacement, la mémoire est physiquement organisée en pages P, représentant la granularité d'effacement. La mémoire est donc divisée en r pages P de tailles identiques. Chaque page comporte un même nombre de mots, constituant la granularité d'écriture (et de lecture). Les pages sont, de préférence, divisées en deux catégories.

Une première catégorie comporte des pages Pl divisées en n trames Fj comportant chacune plusieurs mots de données (ensemble DBj) et un même nombre de mots FMDj de métadonnées de trame (de un à quelques-uns, par exemple trois). Par exemple, toutes les trames comportent un même nombre de mots de données. Chaque page Pl comporte en outre un nombre m (quelques-uns à quelques dizaines) de mots de métadonnées de page PMDl (k) indépendant des trames. Le nombre de mots de données de chaque trame correspond, de préférence, à un multiple entier (au moins 1) du nombre de mots de données de chaque bloc DB de l'organisation virtuelle de la mémoire. Ainsi, une trame Fj contient un bloc de donnée DBj et des métadonnées de trame FMDj. En figure 3, on a illustré, pour chaque trame, le bloc DBj suivi des métadonnées FMDj. Toutefois, de préférence et comme on le verra par la suite, une partie des métadonnées est écrite au début de chaque trame Fj.

Une deuxième catégorie de pages, en nombre nettement plus réduit que le nombre de pages Pl de la première catégorie, ne contient que des mots de métadonnées de mémoire MMDh.

De préférence, la deuxième catégorie ne comporte qu'une page Pr et la première catégorie comporte donc r-1 pages Pl.

En variante, on ne prévoit que des pages de la première catégorie.

Selon un mode de réalisation particulier, une page contient 1024 octets. On prévoit r-1 pages Pl de la première catégorie, contenant chacune 25 trames de 10 mots chacune et 6 mots de métadonnées PMDl de page. Chaque trame Fj contient un bloc DBj, de huit mots W de données, et trois mots de métadonnées de trame FMDj. Par ailleurs, on prévoit une seule page Pr de mots MMDh de métadonnées de mémoire.

Il s'agit d'un exemple particulier et d'autres granularités peuvent être prévues pourvu que, de préférence, tous les mots aient la même taille, représentant la granularité d'écriture dans la mémoire. En particulier, on peut prévoir des blocs logiques Bi de taille (nombre de mots) variable qui sont alors susceptibles d'être répartis dans plusieurs blocs DBj dans plusieurs trames. En variante, des mots de métadonnées ont une taille différente afin, notamment si les données sont de faible taille, de gagner de la place.

Les métadonnées de trame FMDj contiennent au moins un mot FCONST (de préférence un seul mot FMDj (1)) de valeur fixe, identique quelle que soit la valeur des données contenues dans le bloc DBj et au moins un mot (de préférence un seul mot FMDj (2)) contenant le ou les numéros (identifiant(s) i) du ou des blocs virtuels Bi écrits dans le bloc réel DBj. Le mot FMDj(2) contient également un indicateur FW d'état (fin d'écriture) du bloc DBj et un code de contrôle d'erreur de type CRC, signature ou autre. Les métadonnées de trame servent à l'atomicité de trame, c'est-à-dire indiquent si le bloc DBj contenu dans la trame est stable ou non. Ces deux mots de métadonnées de trame FMDj(1) et FMDj(2) servent à la gestion d'atomicité.

Les métadonnées de trame FMDj contiennent également au moins un mot (par exemple un mot FMDj (3)) contenant une ou plusieurs valeurs d'index. Ces valeurs d'index permettent, à partir de la dernière trame mise à jour, de remonter jusqu'au bloc recherché.

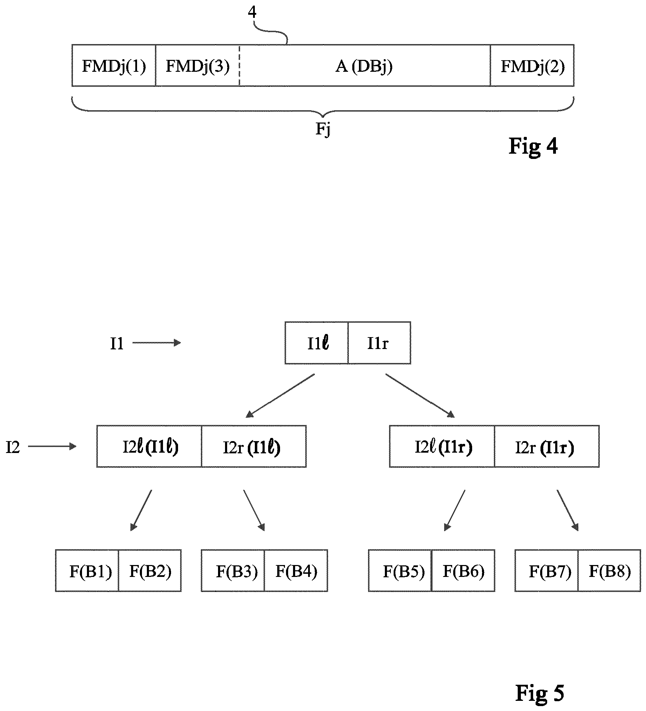

La figure 4 illustre, de façon très schématique, un mode de réalisation d'une structure 4 de trame Fj en supposant deux mots de métadonnées FMDj.

Selon ce mode de réalisation, on écrit en premier le mot de métadonnées FMDj (1) de valeur fixe FCONST, puis le mot de métadonnées FMDj (3) ou d'index, les mots de la donnée A et enfin le mot de métadonnées FMDj(2). En variante, le mot d'index FMDj(3) est stocké entre les mots de la donnée A et le mot de métadonnées FMDj (2). Le code CRC contenu dans le mot FMDj (2) est, de préférence, un CRC des mots FMDj (1) et FMDj(3) et du bloc DBj. Grâce à l'utilisation d'une valeur fixe pour le mot FMDj (1), on sera en mesure de s'assurer qu'il n'y a pas eu d'arrachement ou d'attaque au début de l'écriture de la trame, par exemple une tentative de modification du contenu du bloc DBj lors d'une attaque. La valeur est fixe, c'est-à-dire est la même pour une trame donnée, mais peut varier d'une trame à une autre. De préférence, par facilité, la valeur est la même pour toutes les trames de la mémoire.

Les métadonnées FMDj(3) servent, lors des opérations de lecture à retrouver plus rapidement les données, sans avoir, ni à calculer une table de correspondance complète en mémoire RAM au démarrage, ni à parcourir toute la mémoire flash. On tire en fait profit des particularités de mémorisation dans une mémoire flash pour en transformer les contraintes en avantages. En effet, le fait que l'écriture dans la mémoire s'effectue page par page et trame par trame permet, à partir d'une lecture de la dernière trame et des métadonnées d'index FMDj (3) de remonter à la trame contenant la valeur à jour de n'importe quel bloc. Les métadonnées d'index FMDj (3) représentent, pour chaque trame, un ou plusieurs mots selon la taille de l'index (du nombre total de blocs logiques dans le système).

La figure 5 représente, de façon très schématique, un exemple de structure d'un index dont des valeurs constituent les métadonnées FMDj(3). On suppose, pour simplifier, l'existence de huit blocs B1 à B8 et l'utilisation d'un index binaire pour définir les positions respectives des derniers blocs mis à jour.

A chaque écriture d'un bloc Bi dans une trame sont associés trois niveaux d'index.

L'index de premier niveau I1 comprend un couple de valeurs I1l et I1r représentant les adresses des deux trames contenant les derniers blocs mis à jour respectivement parmi les blocs B1 à B4 et B5 à B8. L'une des deux adresses de trame est donc celle de la trame courante. En supposant par exemple que l'écriture concerne le bloc B4 (i = 4), la valeur I1l correspond à l'adresse de la trame courante.

L'index de deuxième niveau I2 comprend un couple de valeurs I2l et I2r représentant les adresses des deux trames contenant les derniers blocs mis à jour respectivement parmi les deux paires de blocs B1-B2 (I2l (I1l)) et B3-B4 (I2r(I1l)) ou B5-B6 (121(Ilr)) et B7-B8 (I2r(I1r)) dans laquelle se situe le bloc Bi. En continuant avec l'exemple du bloc 4, l'index I2 contient les adresses des deux trames contenant les derniers blocs mis à jour respectivement parmi les blocs B1, B2 et B3, B4. Ici encore, l'une des deux adresses de trame (ici la valeur I2r) correspond à l'adresse de la trame courante.

L'index de troisième niveau I3 comprend un couple de valeurs I3l et I3r représentant les adresses F(Bi) des deux trames contenant les derniers blocs mis à jour respectivement parmi les deux blocs de chaque paire de blocs concernés par l'index de niveau précédent (ici 2). En continuant avec l'exemple du bloc 4, l'index I3 contient les adresses F(B3) et F(B4) des deux trames contenant les derniers blocs mis à jour parmi les blocs B3 à B4. L'une des deux adresses de trame (ici la valeur FB(4)) correspond à l'adresse de la trame courante.

Une telle organisation permet, en lecture, en lisant simplement la métadonnée de trame FMDj(3), de remonter de trame en trame jusqu'à celle contenant le bloc recherché. Dans l'exemple d'un index à trois niveaux, le nombre maximum de trames ayant besoin d'être lues pour retrouver le bloc est trois.

On commence par identifier l'adresse de la dernière trame écrite et par vérifier que le contenu de cette dernière trame écrite est valide. Des exemples de réalisations pour rechercher la dernière trame écrite et valider son contenu seront exposés par la suite. Toutefois, la technique d'index décrite s'applique plus généralement à d'autres applications de stockage en mémoire flash qui ne comprennent pas nécessairement la vérification d'atomicité.

Pour la recherche du bloc Bi, on lit la métadonnée de trame FMDj (3) dans la dernière trame écrite.

On examine la valeur du premier niveau I1 correspondant au bloc recherché (par exemple pour le bloc B4, la valeur I1l). Si cette valeur correspond à l'adresse courante, on examine la valeur de deuxième niveau. Sinon, on arrête l'examen de la trame courante on prend la valeur de premier niveau comme adresse de trame suivante à lire et on revient à l'examen de la valeur d'index de premier niveau. Ici, cette valeur correspond forcément à l'adresse courante. Par conséquent, on peut en variante passer directement à l'examen de la valeur de deuxième niveau.

Ensuite, si la valeur de deuxième niveau I2 de la trame lue correspondant au bloc recherché (ici I2r(I1l)) correspond à l'adresse courante, on examine la valeur de troisième niveau. Sinon, on arrête l'examen de la trame courante, on prend la valeur de deuxième niveau comme adresse de trame suivante à lire et on revient à la lecture de la valeur d'index de premier niveau. Ici, cette valeur de premier niveau, de même que la valeur de deuxième niveau, correspondent forcément à l'adresse courante. Par conséquent, on peut en variante passer directement à l'examen de la valeur de troisième niveau.

Enfin, si la valeur de troisième niveau I3 de la trame lue correspondant au bloc recherché (ici F(B4) ou I3r) correspond à l'adresse courante, on lit le bloc Bi dans la trame courante. Sinon, on prend la valeur de troisième niveau comme adresse de la trame contenant le bloc Bi recherché. On peut vérifier en examinant les valeurs d'index de la nouvelle trame lue mais on est ici en principe sûr que c'est la bonne.

Selon une variante de réalisation, on tire profit du fait qu'une des deux adresses stockées dans chaque niveau d'index correspond à l'adresse de la trame courante. On peut donc se passer de la stocker. Ainsi, on ne stocke qu'une valeur d'index par niveau (plus généralement une valeur de moins que le nombre de branches de l'arbre d'index vers le niveau suivant), celle qui correspond à l'adresse de l'autre sous-ensemble de bloc (en reprenant l'exemple du bloc B4, on stocke uniquement les valeurs I1r, I2l(I1l) et F(B3)). Cela permet de réduire la taille du stockage de l'index donc la taille des trames.

On utilise de préférence un arbre binaire qui constitue le meilleur compromis en termes d'espace de stockage nécessaire pour l'index, mais on peut également appliquer le principe plus généralement à n'importe quel découpage d'arbre. Le nombre de valeurs de chaque niveau (de branches entre le niveau courant et le niveau suivant) n'est par ailleurs pas nécessairement le même pour tous les niveaux. Ce choix dépend de la taille des valeurs d'index souhaitée et du nombre d'index souhaité. Pour un nombre de blocs donné, plus le nombre de niveaux est important, plus le nombre maximum de trames à lire pour atteindre le bloc est important mais moins la taille des trames est importante. Plus le nombre de valeurs par niveau est important, plus la lecture est rapide (on tombe plus rapidement sur le bon bloc) mais plus la taille des trames est importante.

Selon une variante de réalisation de l'index, on exploite une partie de l'index en mémoire RAM et une partie (un ou plusieurs derniers niveaux) de l'index en mémoire flash comme décrit plus haut. Même si le stockage de l'index dans la mémoire RAM impose de stocker toutes les valeurs, c'est-à-dire le niveau complet, le nombre de valeurs par niveau augmentant au fur et à mesure que le niveau augmente, on peut choisir de stocker les premiers niveaux en RAM. Par exemple, pour stocker 1024 blocs avec un index binaire, les cinq premiers niveaux d'arbre contiennent au total 32 valeurs alors que les cinq niveaux suivants contiennent au total 992 valeurs. Un avantage est que cela réduit le temps de lecture car cela réduit le nombre maximum de trames à lire en mémoire flash.

Dans ce cas, on stocke toutes les valeurs de ces premiers niveaux dans les métadonnées de chaque nouvelle page de la mémoire flash. Cela permet d'éviter de devoir analyser toutes les pages au démarrage pour reconstruire l'index. En effet, il suffit de copier les métadonnées d'index de la page courante et ensuite d'analyser les trames programmées (dans la page courante) pour reconstituer l'intégralité de l'index.

Selon un exemple de réalisation, les métadonnées de page PMDl (figure 3) contiennent au moins :
un mot PMDl(1) indicateur que la page a commencé à être écrite et qu'elle n'est plus vierge ;
de préférence mais optionnellement un mot PMDl(2) indicateur que la page est pleine ;
un mot PMDl(3) indicateur que la page suivante est effacée (donc vierge) ;
un mot PMDl(4) indicateur du fait que la page est obsolète, c'est-à-dire qu'aucune des trames ne contient un bloc encore utile (en d'autres termes, que tous les blocs de cette page ont déjà été modifiés dans d'autres pages ultérieurement) ; et
un mot PMDl(5) contenant un numéro d'ordre de la page, c'est-à-dire la valeur d'un compteur PWN de nombre de pages écrites.

Ces métadonnées de page selon cet exemple servent à indiquer le basculement d'une page à une autre et à permettre une récupération d'atomicité au démarrage ou réinitialisation du circuit. Les mots ne sont pas nécessairement physiquement dans cet ordre dans la page.

Selon un autre exemple de réalisation, les métadonnées de page contiennent en outre, ou à la place du mot PMDl(3) indicateur que la page a été effacée, un mot PMDl(6) indicateur du nombre d'effacements qu'a subie la page.

Selon un autre exemple, les métadonnées de page contiennent un ou plusieurs mots supplémentaires PMDl(7) pour stocker la table d'index d'un ou plusieurs premiers niveaux d'index.

A chaque fois que, en remontant de trame en trame en lecture pour rechercher un bloc, on passe dans une autre page, on lit ces premiers niveaux dans les métadonnées de page PMDl(7) et on les stocke en mémoire RAM pour commencer par interpréter les premiers niveaux à partir d'une lecture en mémoire RAM.

Le seul lien entre les tailles logiques et l'organisation physique de la mémoire est que tous les mots ont la même taille. On rappelle que, lorsqu'un mot est vierge (effacé), tous ses bits sont dans un premier état (désigné haut ou 1). La programmation d'un mot pour y stocker une valeur consiste à sélectionner les bits des octets du mot qui doivent changer d'état et être écrits (basculer vers l'état bas ou 0). La programmation d'un drapeau ou indicateur consiste à programmer le bit ou les bits de l'octet à l'état correspondant à l'état bas. On rappelle également qu'une fois écrit ou programmé à l'état 0, le contenu du mot ne peut pas être modifié sauf à effacer la page entière et à la reprogrammer.

L'écriture des données dans la mémoire s'effectue bloc par bloc au fur et à mesure qu'ils sont reçus et successivement dans chaque page. Ainsi, en cas d'écritures successives d'un même bloc logique (par exemple, la valeur d'un compteur), ce même bloc de données Bi peut se retrouver écrit plusieurs fois dans la mémoire avec différentes valeurs au fur et à mesure des écritures. Cela participe à la résolution du problème d'atomicité dans la mesure où, à partir du moment où une donnée A aura été écrite une fois avec une première valeur, on pourra toujours, lors des écritures ultérieures, revenir à la valeur précédente représentant l'état stable en cas de problème d'écriture de la valeur courante.

Par contre, coté mémoire logique 2V, une même donnée A est toujours "stockée" dans le même bloc Bi (ou les mêmes blocs). Ainsi, l'identifiant i (l'adresse) du bloc Bi dans la mémoire logique permet de retrouver le ou les blocs physiques DBj de la mémoire 2 contenant la donnée A (contenant les valeurs successives de la donnée A).

Pour simplifier, on expose par la suite le fonctionnement en supposant arbitrairement que la donnée A que l'on considère occupe un et un seul bloc Bi et que les blocs DBj ont la taille d'un bloc Bi. Toutefois, tout ce qui est décrit s'applique plus généralement au cas pratique où une donnée A peut occuper plusieurs blocs ou une partie de bloc et à des tailles différentes des blocs Bi et DBj.

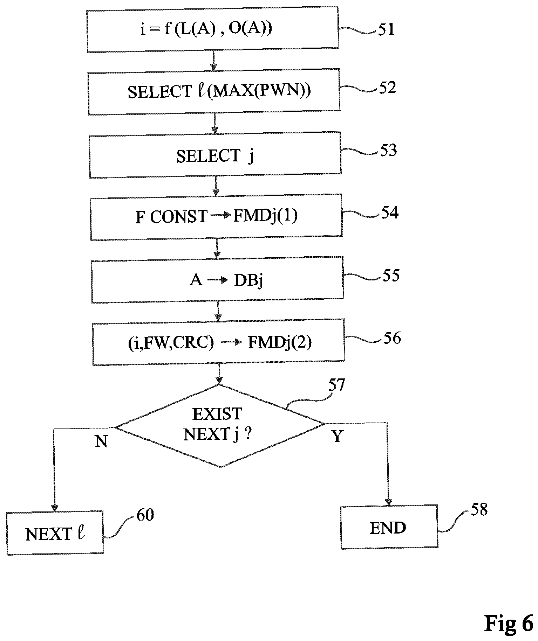

La figure 6 est un schéma-blocs illustrant un mode de réalisation d'une écriture d'une donnée A dans la mémoire 2.

A partir de la longueur L(A) et de l'offset O(A) de la donnée A dans le réseau virtuel 2V (figure 2), le circuit de gestion de la mémoire détermine (bloc 51, i = f(L(A), O(A))) l'identifiant i du bloc DBi contenant cette donnée.

Puis, on sélectionne (bloc 52, SELECT l(MAX(PWN))) la page Pl ayant le nombre de pages écrites PWN le plus élevé en parcourant (en lisant) les mots correspondants PMDl(5) des métadonnées de page.

Puis, on identifie (bloc 53, SELECT j) la première trame Fj disponible séquentiellement dans la page Pl. Cette sélection s'effectue, par exemple, en parcourant les trames successivement jusqu'à la première dont le mot FMDj(1), destiné à la valeur fixe FCONST, n'est pas programmé. En variante, on lit le deuxième mot FMDj (2) de métadonnées et on sélectionne la première trame dont l'indicateur FW de fin d'écriture FMDj est à l'état 1 ou dont l'identifiant de bloc i n'est pas programmé. On suppose dans cet exemple qu'une nouvelle page est ouverte à la fin de l'écriture de la dernière trame d'une page. Par conséquent on trouve forcément une trame disponible à l'étape 53.

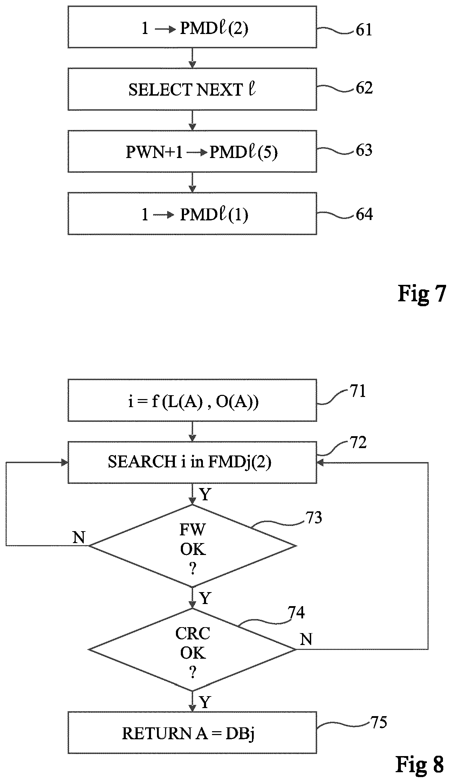

En variante, si aucune trame n'est libre, cela signifie que la page est pleine. On exécute alors une sous-routine d'ouverture d'une nouvelle page. Cette sous-routine sera exposée plus loin en relation avec la figure 8.

Une fois que la trame Fj est sélectionnée, on commence par écrire (bloc 54, FCONST → FMDj(1)), dans la trame Fj, le premier mot FMDj (1) de métadonnées fixe. Il s'agit en fait du premier mot écrit logiquement. Physiquement, les mots peuvent être dans un ordre différent dans la trame. On écrit ensuite (bloc 55, A -> DBj) la donnée A dans le bloc DBj, puis on écrit (bloc 56, (i, FW, CRC) -> FMDj(2)) le deuxième mot FMDj(2) de métadonnées avec l'identifiant i, l'indicateur FW de fin d'écriture et le CRC des premiers mots (FMDj(1) et DBj) de la trame. On écrit également, de préférence avant le mot FMDj(2) afin que l'index soit pris en compte dans la vérification d'atomicité, le ou les mots de métadonnées d'index FMDj(3).

On vérifie alors si la page est pleine, c'est-à-dire s'il existe une trame Fj disponible pour la prochaine écriture (bloc 57, EXIST NEXT j ?). Dans l'affirmative (sortie Y du bloc 57), l'écriture est terminée (bloc 58, END). Dans le cas où une donnée A peut représenter plusieurs blocs DBi, on revient à l'étape 53 pour écrire dans la trame suivante. Dans un cas plus général où les trames sont de taille variable et où l'espace disponible en fin de page n'est pas suffisant pour stocker la trame qui suit, soit on laisse un espace vide, soit on coupe la trame en deux et on stocke une partie sur la page courante et une partie dans la page suivante.

Dans la négative (sortie N du bloc 57), c'est-à-dire s'il n'y a plus de trame disponible, on prépare une page suivante pour la prochaine écriture (bloc 60, NEXT l). Pour simplifier, on considère le cas où l'on prépare la page suivante (index l incrémenté d'une unité) mais on peut, plus généralement, prévoir de lier plusieurs pages ensemble afin d'accélérer la vitesse d'écriture de plusieurs blocs sans effacement intermédiaire. Dans ce cas, on prévoit de sauter une ou plusieurs pages quand une page est pleine.

La figure 7 est un schéma-blocs illustrant un mode de réalisation d'une préparation d'une page suivante pour écriture quand une page courante est pleine.

On commence (bloc 61, 1 -> PMDl(2)) par fermer la page courante, c'est-à-dire par programmer son mot de métadonnées PMDl(2) de fin de page ou de page pleine. Puis (bloc 62, SELECT NEXT l), on sélectionne la prochaine page Pl disponible, c'est-à-dire obsolète. La valeur du nombre de pages écrites, incrémentée de 1, est alors programmée (bloc 63, PWN+1 -> PMDl(5)) dans le mot correspondant PMDl(5) de métadonnées de page et on programme également (bloc 64, 1 -> PMDl(1)) l'indicateur d'ouverture de page.

Avec un tel processus d'écriture dans la mémoire 2, on est en mesure, en lecture, de retrouver la dernière transaction atomique pour chaque donnée.

La figure 8 illustre, sous forme de schéma-blocs, un mode de réalisation d'une lecture atomique d'une donnée A dans la mémoire 2.

A partir de la longueur L(A) et de l'offset O(A) de la donnée A dans le réseau virtuel 2V, le circuit de gestion de la mémoire détermine (bloc 71, i = f(L(A), O(A))) l'identifiant i du bloc Bi contenant cette donnée. La lecture dans la mémoire s'effectue comme illustré ci-dessus, en remontant de trame en trame à partir de la dernière trame écrite de la dernière page écrite (bloc 72, SEARCH i in FMDj(2)).

A chaque trame lue, on vérifie (bloc 73, FW OK ?) l'indicateur d'état FW qui indique si l'écriture de la trame s'est terminée sans arrachement indiquant, en principe, si les données sont stables ou non.

Si l'indicateur d'état n'est pas valide (sortie N du bloc 73), on remonte alors les trames (bloc 72) jusqu'à celle contenant la version précédente du bloc de données DBj.

Si l'indicateur d'état est valide (sortie Y du bloc 73), on vérifie (bloc 74, CRC OK ?) le code d'erreur en recalculant un CRC sur les données présentes dans le premier mot de métadonnées FMDj(1) et dans le bloc de données DBj.

Si le code calculé est identique au code stocké (sortie Y du bloc 74), le bloc de données DBj est valide et la lecture fournit (bloc 75, RETURN A = DBj) la valeur du bloc DBj comme étant la donnée A, donc comme contenu du bloc virtuel Bi.

Si le code CRC n'est pas confirmé (sortie N du bloc 74), cela signifie que les données ne sont pas fiables. On remonte alors la mémoire (bloc 72) afin de trouver la précédente écriture de la donnée, ce qui revient à rechercher la dernière transaction atomique.

Pour remonter dans les trames précédentes, l'index complet est reconstitué sur la base des métadonnées de la page la plus récente (la plus récemment écrite) et des trames écrites dans cette page la plus récente.

En variante, lorsque l'on identifie une trame dont le CRC est erroné (sortie N du bloc 74), on commence par écrire dans le deuxième mot de métadonnées FMDj(2), un indicateur que la trame est polluée. Cela gagne un peu de temps lors de la prochaine lecture de la donnée A car cela évite de recalculer le CRC avant de remonter à l'occurrence précédente.

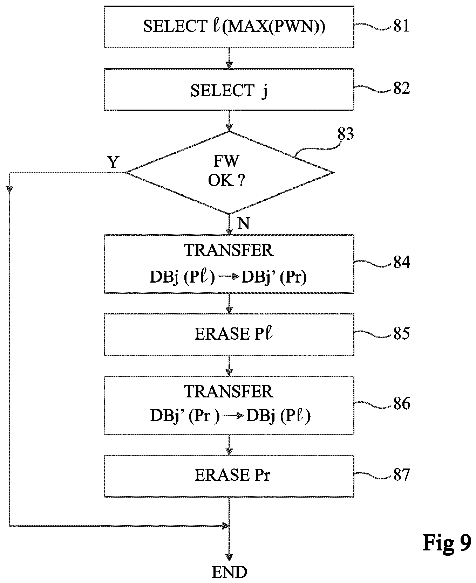

La figure 9 est un schéma-blocs illustrant un mode de réalisation d'une récupération d'atomicité au niveau d'une page.

En pratique, ce processus est effectué au démarrage ou lors d'une réinitialisation du circuit, ce qui revient à vérifier l'atomicité après chaque arrachement ou extinction accidentelle ou volontaire.

On commence par sélectionner (bloc 81, SELECT l(MAX(PWN))) la page ayant la valeur maximale du compteur de nombre de pages écrites. Puis, on sélectionne (bloc 82, SELECT j) la dernière trame écrite dans cette page. On lit alors le deuxième mot de métadonnées FMDj(2) et on vérifie (bloc 83, FW OK ?) que l'indicateur d'écriture FW est correct (est programmé). Dans l'affirmative (sortie Y du bloc 83), il n'y pas de problème d'atomicité et la coupure ou réinitialisation s'est effectuée alors que les processus d'écriture dans la mémoire flash étaient terminés. On passe alors au fonctionnement normal, c'est-à-dire que le processus de vérification d'atomicité est terminé (END). En variante, pour s'assurer qu'il n'y a pas eu d'arrachement en fin d'écriture et pour garantir la stabilité du mot FMDj(2), on reprogramme la même valeur dans le mot FMDj (2).

Dans la négative (sortie N du bloc 83), cela signifie un arrachement (coupure d'alimentation ou réinitialisation) pendant une écriture dans la mémoire flash. Selon un mode de réalisation préféré, on utilise alors la page Pr pour transférer (bloc 84, TRANSFER DBj(Pl) -> DBj'(Pr)) toutes les trames valides de la page Pl vers la page Pr. Puis, on efface la page Pl (bloc 85, ERASE Pl). Les différentes étapes de la copie, vers la page Pr, et ensuite de la recopie, depuis la page Pr, sont validées par des mots de métadonnées dans la page Pr pour s'assurer qu'en cas d'arrachement durant la procédure de récupération, on continue bien la procédure entamée et qu'on ne recommence pas au début de la procédure d'arrachement au risque de perdre définitivement les données encore valables dans la page Pl.

Selon un mode de réalisation, la page Pr est une page dédiée de la mémoire. On effectue alors un transfert inverse (bloc 86, TRANSFER DBj'(Pr) -> DBj(Pl)) des données stockées temporairement dans la page Pr vers la page Pl effacée. Les métadonnées de page sont alors également réécrites. Enfin, on efface la page Pr (bloc 87, ERASE Pr) pour qu'elle soit prête pour une prochaine utilisation.

Selon un autre mode de réalisation, la page Pr est n'importe quelle page disponible. Dans ce cas, il n'est pas nécessaire de transférer les données vers la page Pl après effacement.

De préférence, le processus de la figure 9 comporte également une étape de vérification de l'atomicité des métadonnées de page. Pour cela, on vérifie, lors d'un redémarrage et sur la dernière page écrite, un code correcteur d'erreur stocké dans un des mots de métadonnées de page PMDl(k).

De préférence, avant l'étape 84, on écrit les mots de métadonnées PMDl(2) de toutes les pages qui ont été écrites après la trame Fj sélectionnée au bloc 82, comme indiquant une page pleine. Ainsi, ces pages ne peuvent pas être utilisées sans être effacées.

Selon la variante où l'on utilise que des pages de la première catégorie, on peut se passer de recopier les trames fiables vers une nouvelle page suite à la détection d'une trame erronée. En effet, la trame problématique ne sera de toute façon pas considérée en lecture et on lira la donnée fiable précédente. Toutefois, cela réduit la capacité de la mémoire en termes de nombre d'arrachement qu'elle peut supporter dans la mesure où l'on conserve des trames perdues.

Le nombre de pages disponibles (effacées) est au minimum deux afin de permettre un effacement d'une page. Lorsqu'il n'y a plus de page disponible (autre que les deux minimum), on sélectionne une des pages écrites, de préférence la page dont le nombre de trames écrites est minimum. On parcourt alors cette page à effacer en vérifiant ses trames et celles d'entre-elles qui contiennent les derniers états fiables de blocs Bi. Tous ces blocs sont transférés (écrits) de la manière décrite en relation avec la figure 6 vers une des pages disponibles. Ainsi, au maximum n blocs sont transférés (en pratique, il y a au moins certaines trames qui contiennent des données obsolètes de sorte que ce transfert se traduit par des trames disponibles dans cette page). Une fois le transfert terminé, la page d'origine est effacée. Une fois l'effacement effectué, on programme l'indicateur de page effacée PMDl(4).

En variante, on fixe un nombre minimum de pages supérieur, par exemple trois ou quatre, de façon à disposer de plus de trames disponibles afin de stocker un plus grand nombre de transactions sans requérir un effacement.

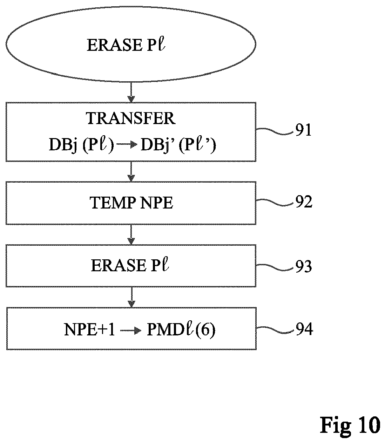

La figure 10 est un schéma-blocs illustrant un autre mode de réalisation d'une sélection d'une page à effacer.

Pour effectuer l'effacement d'une page Pl (ERASE Pl), on commence, comme indiqué ci-dessus par transférer (bloc 91, TRANSFER DBj(Pl) -> DBj'(Pl')) tous les blocs de données DBj de la page Pl dont le contenu représente la dernière valeur stable d'une donnée vers un bloc DBj'(Pl') d'une des pages mémoire disponibles. On stocke (bloc 92, TEMP NPE) un compteur NPE de nombre d'effacements de page dans un mot de métadonnées de la page précédente, puis on efface la page Pl (bloc 93, ERASE Pl). Une fois l'effacement effectué, on programme (bloc 94, NPE+1 → PMDl(6)) le mot de métadonnées PMDl(6) à la valeur du nombre d'effacements incrémenté de un.

Selon ce mode de réalisation, la sélection de la page à effacer ne correspond pas nécessairement à la page ayant la valeur minimale du nombre de pages écrites mais à celle ayant la valeur minimale de pages écrites parmi les pages ayant subi un moindre nombre d'effacements.

L'application de ce mode de réalisation permet d'optimiser la durée de vie de la mémoire flash en optimisant l'homogénéité du nombre d'effacements parmi le nombre de pages. En effet, s'il n'y avait pas de processus de récupération d'atomicité, la page ayant la valeur maximale du nombre de pages écrite serait parmi celles ayant été effacées un moins grand nombre de fois. Toutefois, dans la mesure où l'application du processus de récupération d'atomicité au niveau d'une page se traduit par un transfert, avec la même valeur de nombre de pages écrites vers une page disponible, cela ne correspond pas forcément, notamment en cas de nombreuses mises en oeuvre de la récupération d'atomicité.

On notera que, si ce deuxième aspect peut être combiné au premier, il peut également être mis en oeuvre plus généralement dans tout procédé de gestion d'une mémoire flash.

Un autre avantage est qu'en cas de mise en oeuvre du processus de récupération d'atomicité au niveau d'une page tel que décrit en relation avec la figure 11, il y a un risque que l'erreur soit au niveau du nombre de pages écrites, auquel cas cette page risque, sans la mise en oeuvre du compteur de nombre d'effacements, de ne jamais être effacée.

Un avantage des modes de réalisation qui ont été décrits est qu'ils améliorent la gestion d'une mémoire flash pour le traitement d'opérations devant respecter un critère d'atomicité.

Un autre avantage est qu'ils permettent aisément de remonter à la dernière valeur atomique d'une donnée.

Un autre avantage est que la recherche de la page contenant la donnée recherchée est rapide sans encombrer la mémoire RAM avec une table de correspondance d'adresses.

Pour le cas où l'on ne souhaite pas vérifier l'atomicité au niveau des trames, les métadonnées de trame ne contiennent que les informations d'index. Dans ce cas, on peut ou non maintenir la vérification d'atomicité au niveau des pages.

Divers modes de réalisation ont été décrits. Diverses variantes et modifications apparaîtront à l'homme de l'art. Par ailleurs, la mise en oeuvre pratique des modes de réalisation qui ont été décrits est à la portée de l'homme du métier à partir des indications fonctionnelles données ci-dessus et en utilisant des circuits en eux-mêmes usuels. Notamment, l'organisation de l'adressage de la mémoire et la génération des signaux adaptés à sa commande et à cet adressage fait appel à des techniques en elles-mêmes usuelles.

## Revendications

1. Procédé de gestion d'une mémoire flash (2), dans lequel :
les données (A) à stocker sont organisées en blocs logiques (Bi) ;
la mémoire est divisée en pages (Pl) ;
chaque page est divisée en trames (Fj), chaque trame pouvant contenir au moins un bloc (DBj) de données et au moins un premier mot de métadonnées de trame (FMDj (3)) contenant tout ou partie des valeurs d'index du bloc de données dans un arbre d'index, une valeur d'index correspondant à l'adresse d'une trame.

2. Procédé selon la revendication 1, dans lequel pour chaque niveau d'index, seules les valeurs issues du niveau précédent sont stockées.

3. Procédé selon la revendication 1 ou 2, dans lequel, pour chaque niveau d'index, seules les valeurs issues du niveau précédent à l'exception de la valeur correspondant au bloc concerné sont stockées.

4. Procédé selon l'une quelconque des revendications 1 à 3, dans lequel un ou plusieurs premiers niveaux d'index sont traités dans une mémoire volatile du circuit contenant la mémoire flash.

5. Procédé selon la revendication 4, dans lequel toutes les valeurs desdits un ou plusieurs premiers niveaux d'index sont stockées dans des métadonnées de chaque page.

6. Procédé selon l'une quelconque des revendications 1 à 5, dans lequel les trames (Fj) sont écrites séquentiellement dans une page (Pl).

7. Procédé selon l'une quelconque des revendications 1 à 6, dans lequel la lecture d'un bloc de données comporte au moins les étapes suivantes :
lire la dernière trame écrite dans la mémoire ;
remonter de trame en trame en interprétant les valeurs de ces trames jusqu'à atteindre la trame contenant le bloc recherché.

8. Procédé selon l'une quelconque des revendications 1 à 7, dans lequel une écriture d'un bloc logique dans la mémoire s'accompagne d'une programmation d'un deuxième mot de métadonnées de trame (FMDj(2)) avec un identifiant (i) de ce bloc logique.

9. Procédé selon la revendication 8, dans lequel le deuxième mot de métadonnées de trame (FMDj(2)) contient également une valeur représentative d'un code de contrôle d'erreur calculé au moins à partir du bloc de données (DBj) de la trame.

10. Procédé selon la revendication 9, dans lequel lors de l'écriture d'une trame (Fj), un troisième mot de métadonnées de trame (FMDj(1)) est écrit en premier avec une valeur, indépendante du contenu de la donnée à écrire et qui est toujours la même pour une trame donnée.

11. Procédé selon la revendication 10, dans lequel ledit troisième mot de métadonnées (FMDj(1)) a une valeur fixe pour toutes les trames (Fj) de la mémoire (2).

12. Procédé selon l'une quelconque des revendications 1 à 11, dans lequel chaque page comporte au moins un mot de métadonnées de page (PMD) qui contient, lorsqu'une page est écrite, une valeur d'un compteur (PWN) de nombre de pages écrites, la page dans laquelle procéder à une écriture étant choisie comme étant celle dont le premier mot de métadonnées de page contient la valeur maximum du compteur de pages écrites parmi toutes les pages.

13. Procédé selon la revendication 12, dans lequel ledit premier mot de métadonnées de page (PMDl(5)) est écrit avant écriture d'une première trame (Fj) dans la page (Pl).

14. Procédé selon l'une quelconque des revendications 1 à 13, dans lequel, un circuit de gestion de la mémoire effectue, à chaque démarrage, une vérification d'atomicité de la dernière trame écrite (Fj).

15. Mémoire flash (2), programmée conformément au procédé selon l'une quelconque des revendications 1 à 14.

16. Circuit électronique (1) comportant une mémoire flash (2) conforme à la revendication 15.
